# EUROPEAN PATENT SPECIFICATION

(11) **EP 0 383 011 B1**
(45) Date of publication and mention of the grant of the patent: **13.03.1996**
(21) Application number: 90100445.7
(22) Date of filing: 10.01.1990
(51) Int. Cl.: H01L 29/788, H01L 29/51

(54) **Semiconductor non-volatile memory device**
Nichtflüchtige Speicher-Halbleiteranordnung
Dispositif semi-conducteur de mémoire rémanente

(30) Priority: 17.01.1989 JP 8006/89
(43) Date of publication of application: 22.08.1990
(73) Proprietor: KABUSHIKI KAISHA TOSHIBA, Kawasaki-shi, Kanagawa-ken 210, Tokyo (JP)
(72) Inventor: Mori, Seiichi, 1-1 Shibaura 1-chome, Mitato-ku, Tokyo (JP); Yoshikawa, Kuniyoshi, 1-1 Shibaura 1-chome, Mitato-ku, Tokyo (JP)
(74) Representative: Lehn, Werner, Dipl.-Ing.

(56) References cited:
- EP-A- 0 187 278

## Description

The present invention relates to a nonvolatile semiconductor device with a two-layer gate structure.

In a conventional nonvolatile memory device with a two-layer gate structure, a single-layer thermal oxide film is used as an interlayer insulating film interposed between a floating gate electrode and a control gate electrode. On the other hand, in accordance with miniaturization of semiconductor elements, the thickness of the interlayer insulating film has been reduced. Where the interlayer insulating film is thin, a high electric field is applied to the interlayer insulating film while the memory device is charged. Consequently, there is a concern that the insulating film may be destroyed.

Under the circumstances, the use of an interlayer insulating film with a three-layer structure of an oxide film (first oxide film), a nitride film and an oxide film (hereinafter referred to as ONO structure) has been proposed according to EP-A-0187278 in order to increase a breakdown voltage of the interlayer insulating film. However, since the first oxide film formed directly on a floating electrode is a polycrystalline silicon thermal oxide film in which impurities are diffused at high concentration, the composition of the first oxide film is not uniform, and the quality of the film is not good. Thus, if the semiconductor device is reduced in size and the interlayer insulating film is made thinner, the charge retaining property of the device is degraded.

As stated above, in the prior art, even if the interlayer insulating film between the floating gate electrode and the control electrode has the three-layer structure, the charge retaining property of the device is degraded if the thickness of the insulating film is reduced due to the miniaturization of the semiconductor device.

An object of the present invention is to provide a nonvolatile memory device wherein excellent data retaining properties can be maintained even if the thickness of an interlayer insulating film between a floating gate electrode and a control gate electrode is reduced.

In order to achieve the above object, in the nonvolatile semiconductor memory device of the present invention, an interlayer insulating film formed on a floating gate electrode of e.g., polycrystalline silicon, has a four-layer structure (hereinafter, call NONO structure) in which a first silicon nitride film, a first silicon oxide film, a second silicon nitride film and a second silicon oxide film are laminated in this order on the floating gate electrode.

According to the present invention from another aspect, there is provided a nonvolatile semiconductor memory device having a gate structure with two gate electrodes, said structure comprising, a first gate electrode, a second gate electrode, and an insulating four-layer structure between the first gate electrode and the second gate electrode, the insulating four-layer structure comprising a bottom layer formed on the first gate electrode, the bottom layer being a first silicon nitride layer, a first silicon oxide layer formed on said first silicon nitride layer, a second silicon nitride layer formed on the first silicon oxide layer, and a second silicon oxide layer formed on the second silicon nitride layer.

According to the invention from a still further aspect there is provide a method of forming an interlayer insulating film between a first gate electrode and a second gate electrode in a nonvolatile memory device as defined in the preceding paragraph, comprising the steps of:
forming a first layer of silicon nitride film on the first gate electrode;
forming a first layer of silicon oxide film on the first layer of silicon nitride film;
forming a second layer of silicon nitride film on the first layer of silicon oxide film; and
forming a second layer of silicon oxide film on the second layer of silicon nitride film.

If the thickness of the first silicon nitride film is set to be 60 Å (10 Å = 1nm) or less, injection of holes from the control gate electrode into the first silicon nitride film can be effectively prevented.

If the thickness of the first silicon oxide film is set to be 50 Å or more, the first silicon oxide film can have a sufficient energy gap, and tunneling of carriers through the first silicon oxide film can be prevented.

If the thickness of the second silicon nitride film is set to be 70 Å or more, leakage of electrons from the floating gate electrode can be prevented. Also, if the thickness of the second silicon nitride film is set to be 150 Å or less, injection of holes from the control gate electrode into the second silicon nitride film can be prevented.

It is desirable that the second silicon oxide film have a thickness of 20 Å or more, in order to prevent the injection of holes from the control gate electrode into the second silicon oxide film.

With the above structure, leakage of electrons from the floating gate electrode can be prevented by suitably setting the thickness of each film. The first silicon oxide film can be formed by oxidizing the first silicon nitride film. Thus, the quality of the first silicon oxide film can be enhanced, and accordingly the charge retaining properties of the device can be increased.

Additional objects and advantages of the invention will be set forth in the description which follows, and in part will be obvious from the description, or may be learned by practice of the invention. The objects and advantages of the invention may be realized and obtained by means of the instrumentalities and combinations particularly pointed out in the appended claims.

The accompanying drawings, which are incorporated in and constitute a part of the specification, illustrate a presently preferred embodiment of the invention, and together with the general description given above and the detailed description of the preferred embodiment given below, serve to explain the principles of the invention.
Fig. 1 is a cross-sectional view showing a nonvolatile semiconductor memory device according to an embodiment of the present invention;
Figs. 2A to 2I are cross-sectional views of a semiconductor structure, for explaining a process of manufacturing the semiconductor memory device shown in Fig. 1; and
Fig. 3 shows the amounts of retained carriers in the case where the semiconductor memory device of the present invention as shown in Fig. 1 and a conventional semiconductor memory device are left at a high temperature of 300°C.

An embodiment of the present invention will now be described with reference to the accompanying drawings.

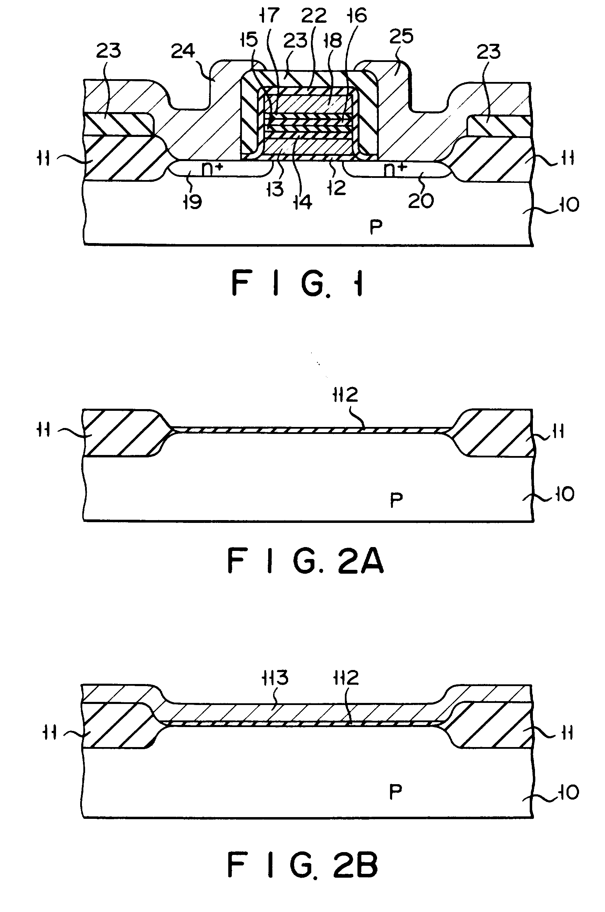

Fig. 1 is a cross-sectional view of an ultraviolet erasure type EPROM cell, to which the present invention has been applied.

A field oxide film 11 for defining a device region is formed in a surface area of a p-type silicon substrate 10. A thermal oxide film 12 is formed in the device region defined by the field oxide film 11. A floating gate electrode 13 of polycrystalline silicon is formed on the thermal oxide film 12. An interlayer insulating film of an NONO structure, wherein a silicon nitride film 14, a silicon oxide film 15, a silicon nitride film 16 and a silicon oxide film 17 are laminated in this order, is formed on the floating gate electrode 13. A control gate electrode 18 is formed on the silicon oxide film 17.

Since the silicon oxide film 15 is formed by oxidizing the silicon nitride film 14, the quality of the silicon oxide film 15 is excellent and the charge (carrier) retaining property thereof is enhanced.

It is desirable that the silicon nitride film 14 have a small thickness, namely, 60 Å or less, so that the injection of holes from the control gate electrode 18 into the silicon nitride film 14 can be prevented as much as possible. Also, it is desirable that the silicon oxide film 15 have a thickness of 50 Å or more, in order for the silicon nitride film 16 to have a sufficient energy gap and in order to prevent tunneling of carriers through the silicon nitride film 16. It is desirable that the silicon nitride film 16 have a thickness of 70 Å or more in order to suppress leakage of electrons from the floating gate electrode 13 and have a thickness of 150 Å or less in order to prevent holes from entering from the control gate electrode 18 into the silicon nitride film 16. Also, it is desirable that the silicon oxide film 17 have a thickness of 20 Å or more in order to prevent holes from entering from the control gate electrode 18 into the silicon oxide film 17.

A source region 19 and a drain region 20 are formed in the device region of the substrate 10. A thin thermal oxide film 22 is formed so as to cover the floating gate electrode 13 and the control gate electrode 18. A CVD (chemical vapor deposition) oxide film 23 of a predetermined pattern for defining a source contact hole and a drain contact hole is formed as a passivation film on the semiconductor structure. A source electrode 24 is formed on the source region 19 and a drain electrode 25 is formed on the drain region 20, respectively, through the source contact hole and the drain contact hole formed in the CVD oxide film 23.

Figs. 2A to 2I are cross-sectional views for illustrating a process for manufacturing the ultraviolet erasure type EPROM cell shown in Fig. 1. In these figures, the same elements as appear in Fig. 1 are denoted by the same reference numerals.

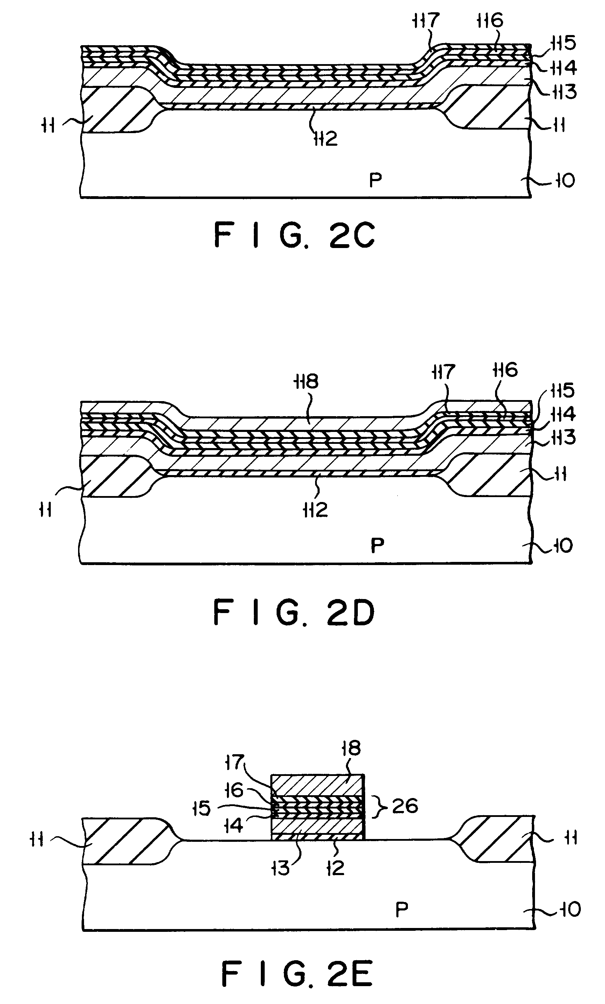

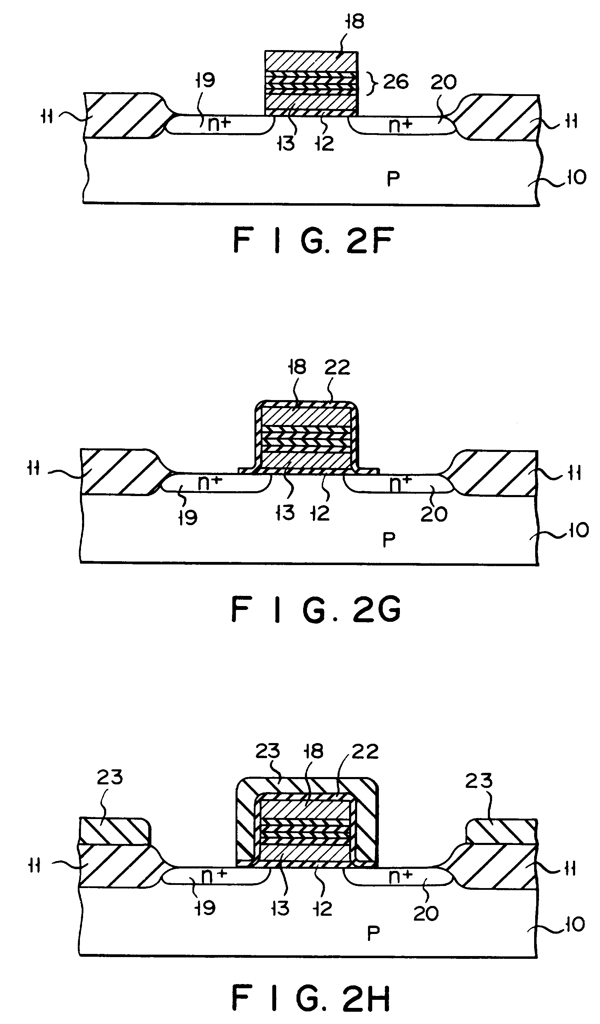

First, as shown in Fig. 2A, a field oxide film 11 for defining a device region is formed in a surface portion of a p-type silicon substrate 10 by a selective oxidation method. The resultant body is subjected to a thermal treatment at about 900°C, whereby a thermal oxide film 112 with a thickness of about 200 Å, a portion of which becomes a first gate insulating film 12, is formed on the device region of the substrate 10. Then, as shown in Fig. 2B, a first polycrystalline silicon film 113 with a thickness of about 4000 Å, a portion of which becomes a floating gate electrode 13, is formed on the semiconductor structure by means of a CVD (chemical vapor deposition) process. Phosphorus is then diffused in the first polycrystalline silicon film 113 at about 900°C, with POCℓ₃ being used as a diffusion source. In the step shown in Fig. 2C, a first silicon nitride film 114 with a thickness of about 110 Å is formed on the first polycrystalline silicon film 113, for example, by means of an LP (low pressure) CVD method. The silicon nitride film 114 is oxidized by a burning oxidation method, and a first silicon oxide film 115 with a thickness of about 90 Å is formed on the silicon nitride film 114. At this time, the silicon nitride film 114 is consumed by about 60 Å and the thickness thereof becomes about 50 Å. Then, a second silicon nitride film 116 with a thickness of about 120 Å is formed on the silicon oxide film 115, for example, by means of the LPCVD method. The second silicon nitride film 116 is oxidized by a burning oxidation method, and a second silicon oxide film 117 with a thickness of about 30 Å is formed on the silicon nitride film 116. At this time, the silicon nitride film 116 is consumed by about 20 Å, and the thickness thereof becomes about 100 Å. As a result, an interlayer insulating film of a four-layer structure, wherein the silicon nitride film 114, silicon oxide film lls, silicon nitride film 116 and silicon oxide film 117 are laminated in this order, is formed on the polycrystalline silicon film 113. In Fig. 2D, a second polycrystalline silicon film 118 with a thickness of about 4000 Å, a portion of which becomes a control gate electrode 18, is formed on the silicon oxide film 117 by means of the CVD method. Phosphorus is diffused in the second polycrystalline silicon film 118 for 30 minutes at about 900°C, with POCℓ₃ being used as a diffusion source. Then, as shown in Fig. 2E, the second polycrystalline silicon film 118, silicon oxide film 117, silicon nitride film 116, silicon oxide film 115, silicon nitride film 114, first polycrystalline silicon film 113, and thermal oxide film 112 are selectively etched in this order by means of a photoetching method. As a result, the floating gate electrode 13, which is a part of the first polycrystalline silicon film 113, is formed on the substrate 10, with the first gate insulating film 12, which is a part of the thermal oxide film 112, being interposed between the floating gate electrode 13 and the substrate 10. A second gate insulating film 26, consisting of interlayer insulating layers 14 (silicon nitride film), 15 (silicon oxide film), 16 (silicon nitride film), and 17 (silicon oxide film), which are parts of the four-layer structure insulating layer (114-117), is formed on the floating gate electrode 13. The control gate electrode 18, which is a part of the second polycrystalline silicon film 118, is formed on the second gate insulating film 26. Subsequently, arsenic is ion-implanted in the substrate 10 with the control gate electrode 18 used as a mask, thus forming n⁺type source and drain regions 19 and 20 in a surface portion of the substrate 10, as shown in Fig. 2F. The semiconductor structure is subjected to thermal oxidation at about 950°C in a dry oxidation atmosphere, to form a thermal oxide film with a thickness of 400 Å. This thermal oxide film is selectively etched in a predetermined pattern, thus forming a thermal oxide film 22 with a thickness of 400 Å on the surfaces of the floating gate electrode 13 and the control gate electrode 18, as shown in Fig. 2G. Then, a CVD oxide film 23 with a thickness of about 0.8 µm, which is doped with phosphorus, is formed as a passivation film on the resultant semiconductor structure. Contact holes are formed in the CVD oxide film 23 by means of a photoetching method, as shown in Fig. 2H. An alloy film formed of aluminum and silicon, with a thickness of 1.0 µm, is formed on the semiconductor structure by means of the CVD method. The alloy film is patterned, and a source electrode 24 is formed on the source region 19 and a drain electrode 25 is formed on the drain region 20, as shown in Fig. 2I.

Through the above process, the EPROM shown in Fig. 1 is formed. According to the above method, there is provided an NONO structure of the silicon nitride film 14, silicon oxide film 15, silicon nitride film 16 and silicon oxide film 17, each having a thickness determined so as to prevent leakage of charge. Since the first silicon oxide film 15 close to the floating gate electrode 13 is obtained by oxidizing the first silicon nitride film 14, the film 15 has a high quality. Thus, electrons charged in the floating gate can be effectively prevented from flowing out to the control gate 18. Thus, the EPROM cell with high charge retaining properties can be provided.

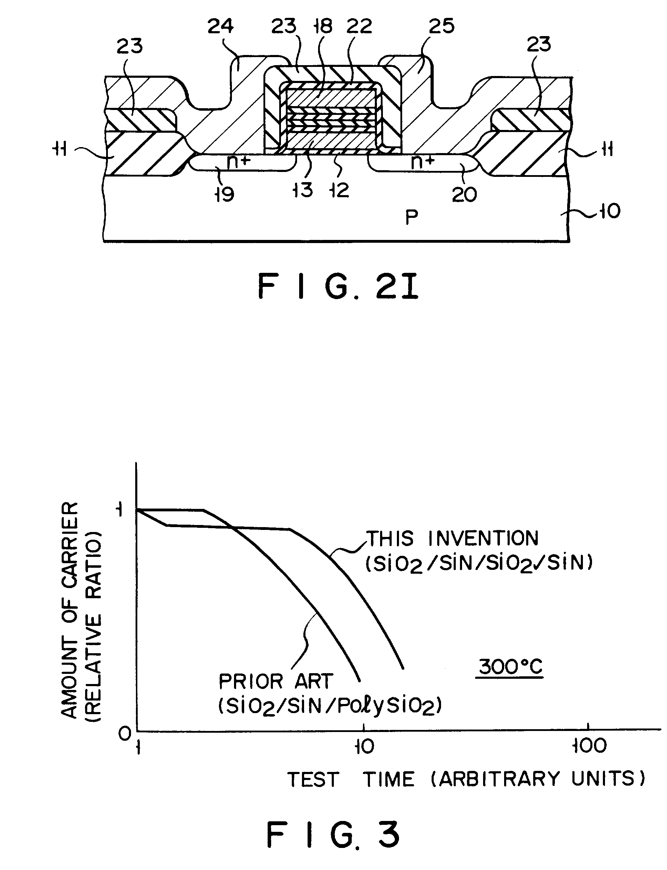

Fig. 3 shows the amounts of retained carriers in the case where the EPROM cell of the present invention as shown in Fig. 1 and a conventional EPROM cell are left at a high temperature of 300°C. As is obvious from Fig. 3, in the initial several hours, the conventional EPROM cell has a greater amount of retained carriers than the EPROM cell of the present invention. However, thereafter, the amount of retained carriers in the EPROM of the present invention becomes remarkably greater.

The above-described embodiment was directed to the EPROM. However, needless to say, the present invention is effectively applicable to other nonvolatile memory devices.

Reference signs in the claims are intended for better understanding and shall not limit the scope.

## Claims

1. A nonvolatile semiconductor memory device having a gate structure with two gate electrodes, said gate structure comprising:
a first gate electrode (13);
a second gate electrode (18); and
an insulating four-layer structure (26) between the first gate electrode and the second gate electrode, the insulating four-layer structure comprising:
a bottom layer (14) formed on the first gate electrode (13), the bottom layer being a first silicon nitride layer (14);
a first silicon oxide layer (15) formed on said first silicon nitride layer (14);
a second silicon nitride layer (16) formed on the first silicon oxide layer (15); and
a second silicon oxide layer (17) formed on the second silicon nitride layer (16).

2. The nonvolatile semiconductor memory device according to claim 1, wherein the thickness of the first silicon nitride layer (14) is less than 6 nm (60 Angstrom).

3. The nonvolatile semiconductor memory device according to claim 1, wherein the thickness of the first silicon oxide layer (15) is more than 5 nm (50 Angstrom).

4. The nonvolatile semiconductor memory device according to claim 1, wherein the thickness of the second silicon nitride layer (16) is between 7 nm (70 Angstrom) and 15 nm (150 Angstrom).

5. The nonvolatile semiconductor memory device according to claim 1, wherein the thickness of the second silicon oxide layer (17) is more than 2 nm (20 Angstrom).

6. A method of forming an interlayer insulating film between a first gate electrode and a second gate electrode in a nonvolatile memory device according to claim 1, comprising the steps of:
forming a first layer (14) of silicon nitride film on the first gate electrode (13);
forming a first layer (15) of silicon oxide film on the first layer of silicon nitride film;
forming a second layer (16) of silicon nitride film on the first layer of silicon oxide film; and
forming a second layer (17) of silicon oxide film on the second layer of silicon nitride film.

7. The method according to claim 6, wherein the first layer of silicon nitride (14) is formed having a thickness less than 6 nm (60 Angstrom).

8. The method according to claim 6, wherein the first layer of silicon oxide (15) is formed having a thickness more than 5 nm (50 Angstrom).

9. The method according to claim 6, wherein the second layer of silicon nitride (16) is formed having a thickness of between 7 nm (70 Angstrom) and 15 nm (150 Angstrom).

10. The method according to claim 6, wherein the second layer of silicon oxide (17) is formed having a thickness of more than 2 nm (20 Angstrom).

11. The method according to claim 6, wherein the first silicon nitride layer (14) is formed by a low pressure chemical vapor deposition method.

12. The method according to claim 6, wherein the first silicon oxide layer (15) is formed by a burning oxidation method.

13. The method according to claim 6, wherein the second silicon nitride layer (16) is formed by a low pressure chemical vapor deposition method.

14. The method according to claim 6, wherein the second silicon oxide layer (17) is formed by a burning oxidation method.

## Patentansprüche

1. Nicht-flüchtige Halbleiterspeichervorrichtung mit einer Gateanordnung mit zwei Gateelektroden, wobei die Gateanordnung aufweist:
eine erste Gateelektrode (13);
eine zweite Gateelektrode (18); und
eine Isolieranordnung (26) mit vier Schichten zwischen der ersten Gateelektrode und der zweiten Gateelektrode, wobei die Isolieranordnung mit vier Schichten aufweist:
eine untere Schicht (14), die auf der ersten Gateelektrode (13) vorgesehen ist, wobei die untere Schicht eine erste Siliziumnitridschicht (14) ist;
eine auf der ersten Siliziumnitridschicht (14) vorgesehene erste Siliziumoxidschicht (15);
eine auf der ersten Siliziumoxidschicht (15) vorgesehene zweite Siliziumnitridschicht (16); und
eine auf der zweiten Siliziumnitridschicht (16) vorgesehene zweite Siliziumoxidschicht (17).

2. Nicht-flüchtige Halbleiterspeichervorrichtung nach Anspruch 1, bei welcher die Dicke der ersten Siliziumnitridschicht (14) weniger als 6 nm (60 Å) beträgt.

3. Nicht-flüchtige Halbleiterspeichervorrichtung nach Anspruch 1, bei welcher die Dicke der ersten Siliziumoxidschicht (15) mehr als 5 nm (50 Å) beträgt.

4. Nicht-flüchtige Halbleiterspeichervorrichtung nach Anspruch 1, bei welcher die Dicke der zweiten Siliziumnitridschicht (16) zwischen 7 nm (70 Å) und 15 nm (150 Å) liegt.

5. Nicht-flüchtige Halbleiterspeichervorrichtung nach Anspruch 1, bei welcher die Dicke der zweiten Siliziumoxidschicht (17) mehr als 2 nm (20 Å) beträgt.

6. Verfahren zur Herstellung eines Zwischenschichtisolierfilms zwischen einer ersten Gateelektrode und einer zweiten Gateelektrode in einer nicht-flüchtigen Speichervorrichtung nach Anspruch 1, mit folgenden Schritten:
Herstellung einer ersten Schicht (14) aus Siliziumnitridfilm auf der ersten Gateelektrode (13);
Herstellung einer ersten Schicht (15) aus Siliziumoxidfilm auf der ersten Schicht aus Siliziumnitridfilm;
Herstellung einer zweiten Schicht (16) aus Siliziumnitridfilm auf der ersten Schicht aus Siliziumoxidfilm; und
Herstellung einer zweiten Schicht (17) aus Siliziumoxidfilm auf der zweiten Schicht aus Siliziumnitridfilm.

7. Verfahren nach Anspruch 6, bei welchem die erste Schicht aus Siliziumnitrid (14) mit einer Dicke von weniger als 6 nm (60 Å) ausgebildet wird.

8. Verfahren nach Anspruch 6, bei welchem die erste Schicht aus Siliziumoxid (15) mit einer Dicke von mehr als 5 nm (50 Å) ausgebildet wird.

9. Verfahren nach Anspruch 6, bei welchem die zweite Schicht aus Siliziumnitrid (16) mit einer Dicke von zwischen 7 nm (70 Å) und 15 nm (150 Å) ausgebildet wird.

10. Verfahren nach Anspruch 6, bei welchem die zweite Schicht aus Siliziumoxid (17) mit einer Dicke von mehr als 2 nm (20 Å) ausgebildet wird.

11. Verfahren nach Anspruch 6, bei welchem die erste Siliziumnitridschicht (14) durch ein chemisches Dampfablagerungsverfahren unter niedrigem Druck ausgebildet wird.

12. Verfahren nach Anspruch 6, bei welchem die erste Siliziumoxidschicht (15) durch ein Glühoxidationsverfahren ausgebildet wird.

13. Verfahren nach Anspruch 6, bei welchem die zweite Siliziumnitridschicht (16) durch ein chemisches Dampfablagerungsverfahren unter niedrigem Druck ausgebildet wird.

14. Verfahren nach Anspruch 6, bei welchem die zweite Siliziumoxidschicht (17) durch ein Glühoxidationsverfahren ausgebildet wird.

## Revendications

1. Dispositif de mémoire à semiconducteur non volatile comportant une structure de grille munie de deux électrodes de grille, ladite structure de grille comprenant:
une première électrode de grille (13) ;
une seconde électrode de grille (18); et
une structure à quatre couches d'isolation (26) entre la première électrode de grille et la seconde électrode de grille, la structure à quatre couches d'isolation comprenant :
une couche inférieure (14) formée sur la première électrode de grille (13), la couche inférieure étant une première couche de nitrure de silicium (14);
une première couche d'oxyde de silicium (15) formée sur ladite première couche de nitrure de silicium (14);
une seconde couche de nitrure de silicium (16) formée sur la première couche d'oxyde de silicium (15); et
une seconde couche d'oxyde de silicium (17) formée sur la seconde couche de nitrure de silicium (16).

2. Dispositif de mémoire à semiconducteur non volatile selon la revendication 1, dans lequel l'épaisseur de la première couche de nitrure de silicium (14) est inférieure à 6 nm (60 angströms).

3. Dispositif de mémoire à semiconducteur non volatile selon la revendication 1, dans lequel l'épaisseur de la première couche d'oxyde de silicium (15) est supérieure à 5 nm (50 angströms).

4. Dispositif de mémoire à semiconducteur non volatile selon la revendication 1, dans lequel l'épaisseur de la seconde couche de nitrure de silicium (16) est entre 7 nm (70 angströms) et 15 nm (150 angströms).

5. Dispositif de mémoire à semiconducteur non volatile selon la revendication 1, dans lequel l'épaisseur de la seconde couche d'oxyde de silicium (17) est supérieure à 2 nm (20 angströms).

6. Procédé de formation d'un film d'isolation intercouche entre une première électrode de grille et une seconde électrode de grille dans un dispositif de mémoire non volatile selon la revendication 1, comprenant les étapes de :
formation d'une première couche (14) constituée par un film de nitrure de silicium sur la première électrode de grille (13) ;
formation d'une première couche (15) constituée par un film d'oxyde de silicium sur la première couche constituée par un film de nitrure de silicium ;
formation d'une seconde couche (16) constituée par un film de nitrure de silicium sur la première couche constituée par un film d'oxyde de silicium ; et
formation d'une seconde couche (17) constituée par un film d'oxyde de silicium sur la seconde couche constituée par un film de nitrure de silicium.

7. Procédé selon la revendication 6, dans lequel la première couche de nitrure de silicium (14) est formée de manière à présenter une épaisseur inférieure à 6 nm (60 angströms).

8. Procédé selon la revendication 6, dans lequel la première couche d'oxyde de silicium (15) est formée de manière à présenter une épaisseur supérieure à 5 nm (50 angströms).

9. Procédé selon la revendication 6, dans lequel la seconde couche de nitrure de silicium (16) est formée de manière à présenter une épaisseur entre 7 nm (70 angströms) et 15 nm (150 angströms).

10. Procédé selon la revendication 6, dans lequel la seconde couche d'oxyde de silicium (17) est formée de manière à présenter une épaisseur supérieure à 2 nm (20 angströms).

11. Procédé selon la revendication 6, dans lequel la première couche de nitrure de silicium (14) est formée au moyen d'un procédé de dépôt chimique en phase vapeur basse pression.

12. Procédé selon la revendication 6, dans lequel la première couche d'oxyde de silicium (15) est formée au moyen d'un procédé d'oxydation par combustion.

13. Procédé selon la revendication 6, dans lequel la seconde couche de nitrure de silicium (16) est formée au moyen d'un procédé de dépôt chimique en phase vapeur basse pression.

14. Procédé selon la revendication 6, dans lequel la seconde couche d'oxyde de silicium (17) est formée au moyen d'un procédé d'oxydation par combustion.
